Europäisches Patentamt

European Patent Office

Office européen des brevets

(19)

(11)  **EP 0 757 435 A1**

(12)  **EUROPÄISCHE PATENTANMELDUNG**

(43) Veröffentlichungstag:
05.02.1997  **Patentblatt 1997/06**

(51) Int. Cl.⁶: **H03F 3/60**, H01P 5/02

(21) Anmeldenummer: 96106893.9

(22) Anmeldetag: 02.05.1996

(84) Benannte Vertragsstaaten:
**CH DE ES FR GB IT LI SE**

(30) Priorität: **02.08.1995 DE 19528311**

(71) Anmelder: **ROBERT BOSCH GMBH**
**70442 Stuttgart (DE)**

(72) Erfinder:
• **Junger, Klaus, Ing.**
**71573 Allmersbach/Tal (DE)**
• **Schwarzhorn, Joachim, Dipl.-Ing**
**71546 Aspach (DE)**

(54)  **Anordnung zum Reduzieren der Welligkeit der Übertragungsfunktion einer Mikrowellen-Kettenschaltung**

(57)    Die Welligkeit der Übertragungsfunktion einer Mikrowellen-Kettenschaltung läßt sich auf einfache Weise dadurch reduzieren, daß in die an sich gleich langen Verbindungsleitungen (V1,...,Va-1) zwischen jeweils der n-ten und (n+1)-ten (n = 1,...,a) von insgesamt a vorhandenen Mikrowellenschaltungen (S1,...,Sa) eine Leitung (L1,...,La) der Länge

$$l_n = \frac{1}{a-1} \cdot \frac{\lambda}{2} \cdot (n-1)$$

eingefügt ist.

Bei einer ungeradigen Anzahl von in Kette geschalteten Mikrowellenschaltungen reicht es aus, alternierend in ein um die andere Verbindungsleitung zwischen zwei Mikrowellenschaltungen eine Leitung der Länge

$$l = k \cdot \frac{\lambda}{4} \qquad (k = 1,3,5,...)$$

einzufügen.

Fig. 1

EP 0 757 435 A1

# Beschreibung

Stand der Technik

Die vorliegende Erfindung betrifft eine Anordnung zum Reduzieren der Welligkeit der Übertragungsfunktion einer Kettenschaltung aus mehreren gleichen Mikrowellenschaltungen.

Werden mehrere gleiche Mikrowellenschaltungen

- beispielsweise Verstärker - in Kette geschaltet, so bilden sich in der Übertragungsfunktion der Kettenschaltung, insbesondere wenn die Schaltungen hohe Reflexionsfaktoren am Ein- und Ausgang aufweisen, eine hohe unerwünschte Welligkeit aus. Das geschieht auch dann, wenn die Übertragungsfunktionen der einzelnen Schaltungen selbst keine Welligkeit aufweisen.

Der Erfindung liegt daher die Aufgabe zugrunde, eine Anordnung der eingangs genannten Art anzugeben, die mit möglichst wenig aufwendigen Mitteln die Welligkeit der Übertragungsfunktion reduziert.

Vorteile der Erfindung

Erfindungsgemäß wird diese Aufgabe durch die Merkmale des Anspruchs 1 oder des Anspruchs 2 gelöst. Nach der Erfindung reichen lediglich zusätzliche in die an sich gleich langen Verbindungsleitungen zwischen den Mikrowellenschaltungen eingefügte Zusatzleitungen aus, um die Welligkeit der Übertragungsfunktion kaskadierter Mikrowellenschaltungen zu reduzieren. Diese zusätzlichen Leitungen können auf einfache Weise zusammen mit den sowieso vorhandenen Verbindungsleitungen zwischen den einzelnen Mikrowellenschaltungen hergestellt werden. Gemäß dem Anspruch 1 hängt die Länge der zwischen den einzelnen Mikrowellenschaltungen eingefügten Leitungen von der Gesamtzahl der in Kette geschalteten Mikrowellenschaltungen ab. Nach Anspruch 2 brauchen bei einer ungeradzahligen Anzahl von Mikrowellenschaltungen nur alternierend in ein um die andere Verbindungsleitung zwischen zwei Mikrowellenschaltungen λ/4 lange Leitungen eingefügt zu werden.

Beschreibung von Ausführungsbeispielen

Anhand mehrerer in der Zeichnung dargestellter Ausführungsbeispiele wird nachfolgend die Erfindung näher erläutert. Es zeigen Figur 1 eine Kaskadierung beliebig vieler Mikrowellenschaltungen, Figur 2 eine Kaskadierung von drei und Figur 3 eine Kaskadierung von fünf Mikrowellenschaltungen.

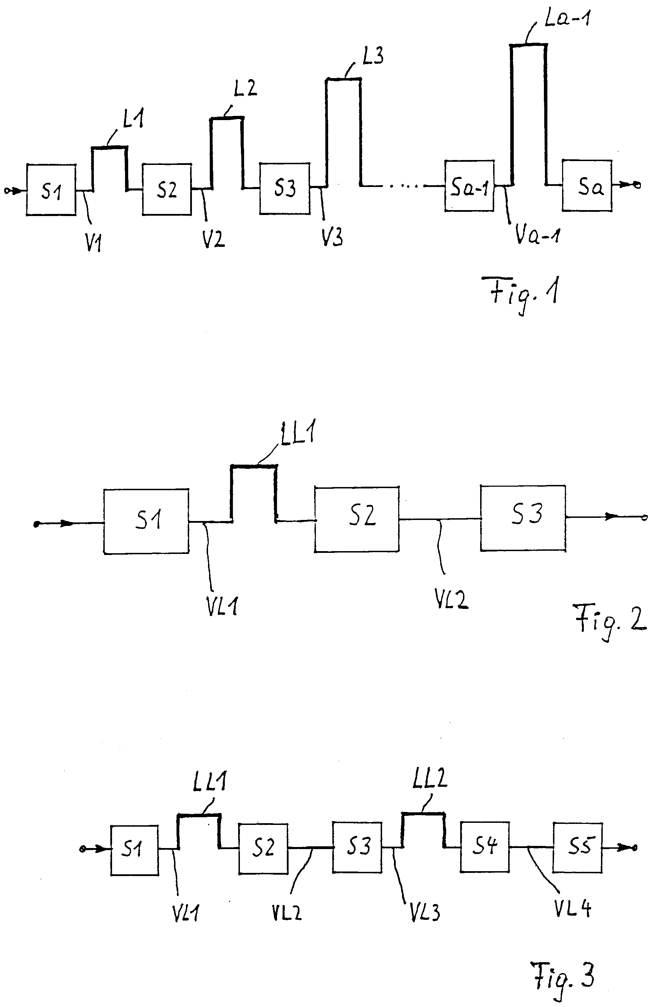

In der Figur 1 ist eine Kettenschaltung aus einer Anzahl von a-gleichen Mikrowellenschaltungen S1, S2 und S3 ... Sa-1 und Sa - z. B. Hochfrequenzverstärkern - dargestellt. Es handelt sich um rückwirkungsarme Mikrowellenschaltungen S1, ..., Sa, d. h. Schaltungen, deren Rückwirkung vom Ausgang zum Eingang sehr stark gedämpft ist. Bei hohen Reflexionsfaktoren an den Ein- und Ausgängen der einzelnen Mikrowellenschaltungen entsteht in der Übertragungsfunktion der Kettenschaltung eine starke unerwünschte Welligkeit. Durch Einfügungen von Leitungen L1, L2, L3 ..., La-1 in die Verbindungsleitungen V1, V2, V3, ..., Va-1 zwischen den einzelnen Mikrowellenschaltungen S1, S2, S3, ... Sa-1, Sa geht die Welligkeit der Übertragungsfunktion deutlich zurück. Dabei ist davon auszugehen, daß alle Verbindungsleitungen V1, ...,Va-1 zwischen den einzelnen Mikrowellenschlatungen S1,...,Sa ohne die zusätzlich eingefügten Leitungen L1,...,La-1 gleich lang sind. Als Sonderfall haben alle Verbindungsleitungen V1,...,Va-1 die Länge 0; dann sind die Mikrowellenschaltungen allein über die Leitungen L1,...,La-1 miteinander verbunden. Wie der Figur 1 zu entnehmen ist, nimmt die Länge der Leitungen L1,...,La-1 von einer Mikrowellenschaltung zur nächsten zu. Allgemein beträgt die Länge der zwischen der n-ten und (n + 1)-ten (n = 1, ... a) Mikrowellenschaltung eingefügten Leitung Ln

$$l_n = \frac{1}{a\text{-}1} \cdot \frac{\lambda}{2} \cdot (n\text{-}1)$$

Maßgebend für die Reduzierung der Welligkeit der Übertragungsfunktion der Kettenschaltung sind die durch das Einfügen der Leitungen L1,...,La-1 entstehenden relativen Längenunterschiede zwischen den die einzelnen Mikrowellenschaltungen S1,...,Sa miteinander verbindenden Leitungen.

Idealerweise hat jede in einer Verbindungsleitung V1,...,Va-1 eingefügte Leitung L1,...,La-1 die Nennimpedanz der zugehörigen Verbindungsleitung V1,...,Va-1.

Sofern es sich um eine ungeradzahlige Anzahl von kaskadierten Mikrowellenschaltungen handelt, z.B. drei oder fünf Mikrowellenschaltungen, wie in Figur 2 und 3 dargestellt, braucht nur alternierend in ein um die andere Verbindungsleitung VL1,...,VL4 zwischen zwei Mikrowellenschaltungen eine Leitung der Länge

$$l = k \cdot \frac{\lambda}{4} \qquad (k = 1,3,5,...)$$

eingefügt zu werden. λ ist die mittlere Wellenlänge des Übertragungsfrequenzbandes der Kettenschaltung. Wie bereits oben zu den Verbindungsleitungen V1,...,Va-1 ausgeführt, sind auch die Verbindungsleitungen VL1,...,VL4 gleich lang.

In Figur 2 ist beispielsweise eine Leitung LL1 in die Verbindungsleitung VL1 zwischen den Mikrowellenschaltungen S1 und S2 eingefügt. Statt in die Verbindungsleitung VL1 kann die zusätzliche k*λ/4 lange Leitung auch in die Verbindungsleitung VL2 zwischen den Mikrowellenschaltungen S2 und S3 eingefügt werden.

Eine Kettenschaltung aus fünf gleichen rückwirkungsarmen Mikrowellenschaltungen S1, S2, S3, S4 und S5 ist der Figur 3 zu entnehmen. Hier sind zwei in Verbindungsleitungen zwischen benachbarten Schaltungen eingefügte k*λ/4 lange Leitungen erforderlich, um die Welligkeit der Übertragungsfunktion zu reduzieren. In dem dargestellten Ausführungsbeispiel ist in die Verbindungsleitung VL1 zwischen den beiden Schaltungen S1 und S2 eine k*λ/4 lange Leitung LL1 und in die übernächste Verbindungsleitung VL3 zwischen den beiden Schaltungen S3 und S4 eine k*λ/4 lange Leitung LL2 eingefügt. Statt k*λ/4 lange Leitungen LL1 und LL2 in die Verbindungsleitung VL1 und VL3 einzufügen, können ebenso k*λ/4 lange Leitungen in den Verbindungsleitungen VL2 und VL4 vorgesehen werden.

Wie in den Figuren 2 und 3 dargestellt, sind die zusätzlich eingefügten k*λ/4 langen Leitungen LL1, LL2 bei einer ungeradzahligen Anzahl von Mikrowellenschaltungen gleich lang.

**Patentansprüche**

1. Anordnung zum Reduzieren der Welligkeit der Übertragungsfunktion einer Kettenschaltung mehrerer gleicher Mikrowellenschaltungen, dadurch gekennzeichnet, daß in die an sich gleich langen Verbindungsleitung (V1,...,Va-1) zwischen jeweils der n-ten und (n+1)-ten (n = 1,...,a) von insgesamt a vorhandenen Mikrowellenschaltungen (S1,...,Sa) eine Leitung (L1,...,La-1) der Länge

$$l_n = \frac{1}{a-1} \cdot \frac{\lambda}{2} \cdot (n\text{-}1)$$

eingefügt ist.

2. Anordnung zum Reduzieren der Welligkeit der Übertragungsfunktion einer Kettenschaltung mehrerer gleicher Mikrowellenschaltungen, dadurch gekennzeichnet, daß bei einer ungeradzahligen Anzahl von Mikrowellenschaltungen (S1,...,S5), die alle über gleich lange Verbindungsleitungen (VL1,...,VL4) in Kette geschaltet sind, alternierend in ein um die andere Verbindungsleitung (VL1,VL3) zwischen zwei Mikrowellenschaltungen (S1,...,S5) eine Leitung (LL1,LL2) der Länge

$$l = k \cdot \frac{\lambda}{4} \qquad (k = 1,3,5,...)$$

eingefügt ist.

3. Anordnung nach Anspruch 1 oder 2, dadurch gekennzeichnet, daß die Impedanz jeder eingefügten Leitung (L1,...,La-1, LL1,LL2) gleich der Nennimpedanz der Verbindungsleitung (V1,...,Va-1, VL1,...,VL4) ist, in welche sie eingefügt ist.

4. Anordnung nach Anspruch 1 oder 2, dadurch gekennzeichnet, daß die Mikrowellenschaltungen (S1,...,Sa) Verstärker sind.

*Fig. 1*

*Fig. 2*

*Fig. 3*

4

**Europäisches Patentamt**

# EUROPÄISCHER RECHERCHENBERICHT

Nummer der Anmeldung

EP 96 10 6893

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DE-A-19 01 990 (NIPPON ELECTRIC COMPANY LTD)<br>* Seite 5, Zeile 7 - Zeile 11 *<br>* Seite 13, Zeile 11 - Seite 14, Zeile 14; Abbildungen 1-9 *<br>--- | 1-4 | H03F3/60<br>H01P5/02 |
| X | ELECTRONICS AND COMMUNICATIONS IN JAPAN, Bd. 53b, Nr. 2, Februar 1970, NEW YORK US,<br>Seiten 106-113, XP002015881<br>K. AYAKI ET AL.: "A 4-GHz multi-stage transistor amplifier of new circuit configuration"<br>* Seite 107, linke Spalte, Zeile 32 - Seite 108, linke Spalte, Zeile 32; Abbildungen 4,7,12 *<br>--- | 1,3,4 | |
| X | NEC RESEARCH AND DEVELOPMENT, Bd. 8, Nr. 12, Oktober 1968, TOKYO JP,<br>Seiten 16-20, XP002015882<br>K. AYAKI ET AL.: "4 GHz transistor amplifier"<br>* Abbildung 7 *<br>--- | 2-4 | |
| A | DE-B-11 16 282 (N.V. PHILIPS' GLOEILAMPENFABRIEKEN)<br>* Spalte 3, Zeile 4 - Spalte 4, Zeile 11; Abbildung *<br>----- | 1,4 | |

| RECHERCHIERTE SACHGEBIETE (Int.Cl.6) |
|---|
| H03F<br>H01P |

Der vorliegende Recherchenbericht wurde für alle Patentansprüche erstellt

| Recherchenort | Abschlußdatum der Recherche | Prüfer |
|---|---|---|
| DEN HAAG | 15.Oktober 1996 | Den Otter, A |

EPO FORM 1503 03.82 (P04C03)